# EUROPEAN PATENT APPLICATION

(11) **EP 1 382 627 A2**
(43) Date of publication of application: **21.01.2004**
(21) Application number: 03253872.0
(22) Date of filing: 19.06.2003
(51) Int. Cl.: C08G 63/06, C08G 63/60, C09K 19/38

(54) **Material for piezoelectric transduction**

(30) Priority: 19.06.2002 JP 2002179129
(71) Applicant: Fuji Photo Film Co., Ltd., Kanagawa (JP)
(72) Inventor: Sato, Masao, Fujinomiya-shi, Shizuoka (JP)
(74) Representative: Hill, Christopher Michael

(57) **Abstract**

The present invention provides a material for piezoelectric transduction which is suitable for a usage that requires maintaining sufficient piezoelectricity and heat-resistance, even if stored at high temperature for a long period. The material for piezoelectric transduction includes a main chain liquid crystal polymer. Preferable aspects are that the main chain liquid crystal polymer contains a constitutional unit including a cyclic group, a connected portion, a functional unit, and a spacer portion, as a repeated unit, that the main chain liquid crystal polymer is at least one selected from polyester, aromatic polymer, and aromatic polyester, and that a decay rate, which is defined as ((α-β)/α), in which α is the piezoelectricity of the material for piezoelectric transduction at room temperature prior to heating and β is the piezoelectricity of the same after seven days of continuous heating at 85 °C, is equal to or less than 0.1.

## Description

### BACKGROUND OF THE INVENTION

### Field of the Invention

The present invention relates to a material for piezoelectric transduction which can be suitably used in various fields as a damping material and the like.

### Description of the Related Art

A material which can transduce strain energy into electric energy when pressurized, has been widely used in various fields such as a sensor or the like. Conventionally, inorganic materials have been widely used for the material for piezoelectric transduction. However, there are limitations on the inorganic materials to use as the material for piezoelectric transduction. Accordingly, tremendous research has been recently conducted on a material for piezoelectric transduction as an organic material. Ferroelectric polymer such as PVDF, VDF/TrFE, or the like, ferroelectric liquid crystal, optically active polymer such as cellulose derivative that is uniaxially oriented, and the like, have been developed.

PVDF, which has good piezoelectric properties (which may be referred to as piezoelectricity), has been widely used as the organic material, however, the PVDF has a disadvantage that the piezoelectric properties can easily be deteriorated by heat because of its low glass transition temperature (Tg). Unable to maintain its initial performance for a long period of time, the PVDF is not suitable for the organic material in a usage requiring heat resistance. In addition, it is difficult to increase the thickness of a film made of a ferroelectric liquid crystal, and piezoelectricity of substances like cellulose are not based on polarity and therefore such substances have the defect in that their piezoelectricities are inherently small.

Therefore, a material for piezoelectric transduction has not been provided yet to date which is free of such issue, absorbs external vibration and the like as strain energy to efficiently transduce the energy to electricity, can dissipate the electricity as heat, maintains sufficient piezoelectricity even though being kept at high temperature for a long period, and is suitable for a usage which requires heat resistance.

### SUMMARY OF THE INVENTION

It is an object of the present invention to provide a material for piezoelectric tranduction which maintains sufficient piezoelectric performance even if stored at high temperature for a long period, can be suitable for usage when requiring heat resistance, can be produced at low cost, and is excellent in mass production and handling. The problems in the related art can be solved by the following aspects of the present invention.

According to a first aspect of the present invention, the material for piezoelectric transduction of the present invention comprises a main chain liquid crystal polymer.

### BRIEF DESCRIPTION OF THE DRAWINGS

FIG. 1 is a schematic view showing an example that a polarizability of the material for piezoelectric transduction increases in accordance with polymerization degree of monomer unit in the material for piezoelectric transduction.
FIG. 2 is a schematic view showing another example that a polarizability of the material for piezoelectric transduction increases in accordance with polymerization degree of monomer unit in the material for piezoelectric transduction.

### DESCRIPTION OF THE PREFERRED EMBODIMENTS

The material for piezoelectric transduction comprises a main chain liquid crystal polymer. The material for piezoelectric transduction may further comprise other components suitably selected according to purposes.

There is no particular limitation on the main chain liquid crystal polymer, and can be suitably selected according to purposes, as long as it shows second harmonic generation (SHG) activity. Examples of the main chain liquid crystal polymer may or may not include a constitutional unit having a cyclic group, as a repeated unit.

These may be used either alone or in combination of two or more. Among these, a polyester is preferable, an aromatic polymer is more preferable, and an aromatic polyester is particularly preferable.

The aromatic polyester is not specifically limited, and can be selected appropriately in accordance with the object. Examples of the aromatic polyester may or may not include at least one selected from aromatic diol, aromatic dicarboxylic acid, and aromatic hydroxycarboxylic acid, shown in TABLE 1, as a monomer unit.

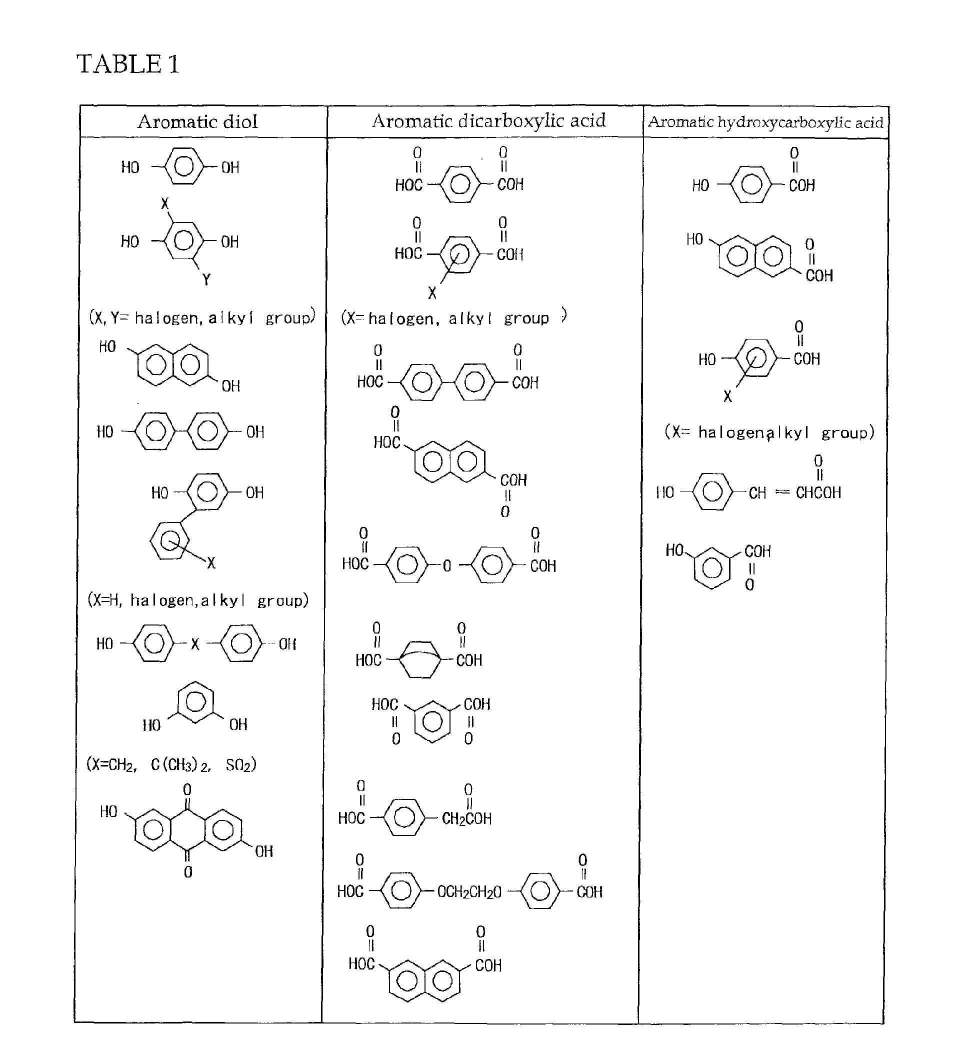

A preferable example of the aromatic polymer includes a structure expressed by the following Formula (1):

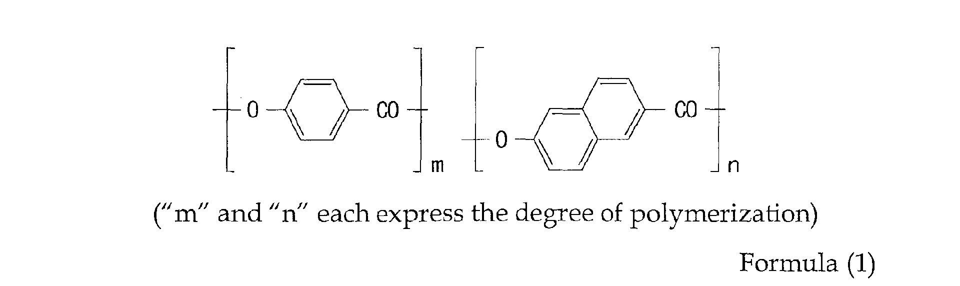

In the above Formula (1), a ratio (m:n) of "m" and "n" is not particularly limited, and can be suitably selected according to purposes. The ratio is 90:10 to 50:50, and more preferably 80:20 to 60:40.

Preferable examples of the aromatic polymer include those expressed by the following Formulae (2) to (20).

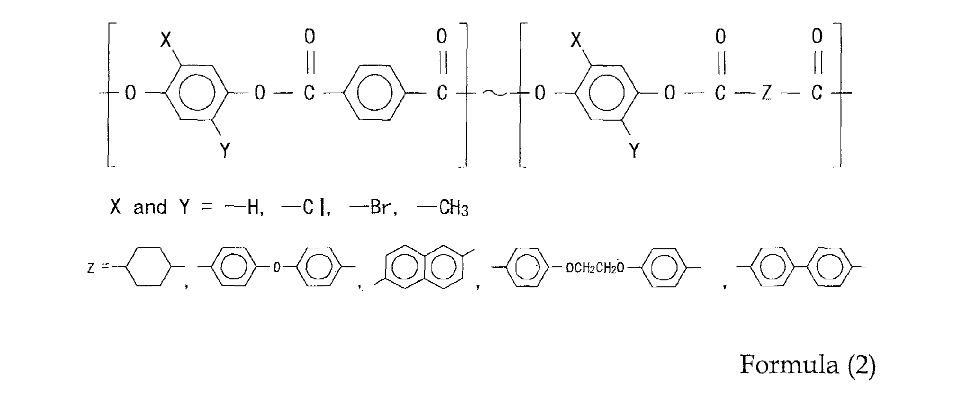

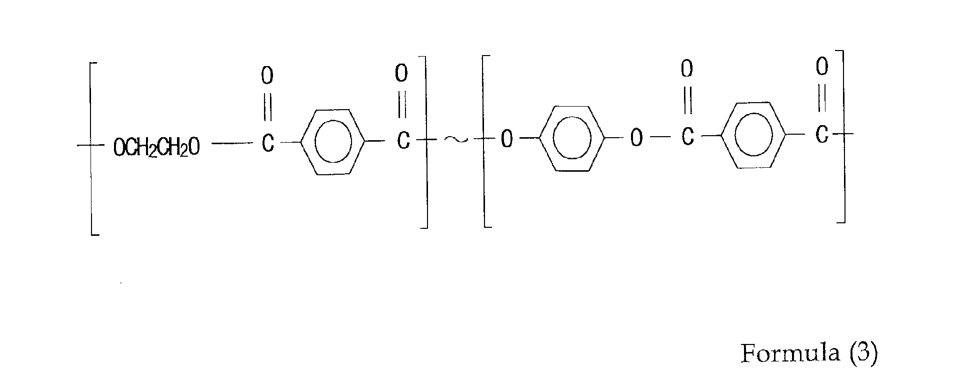

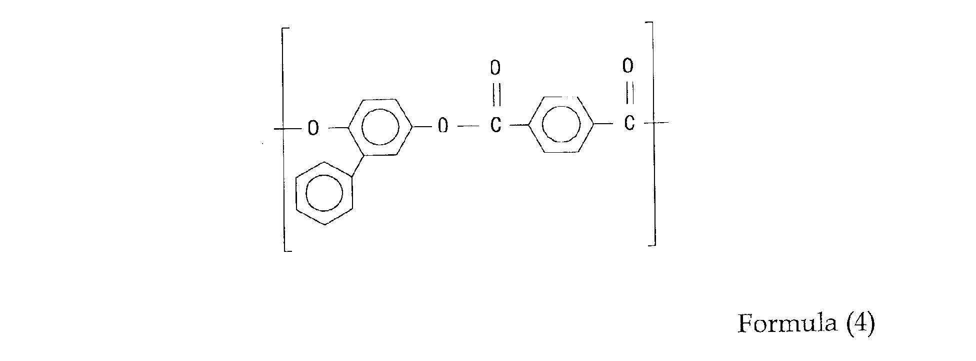

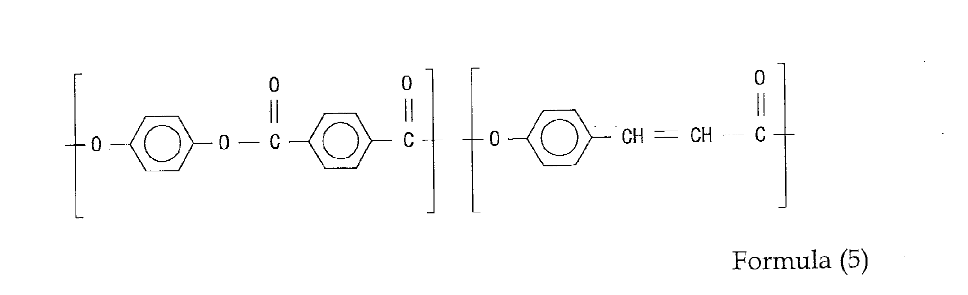

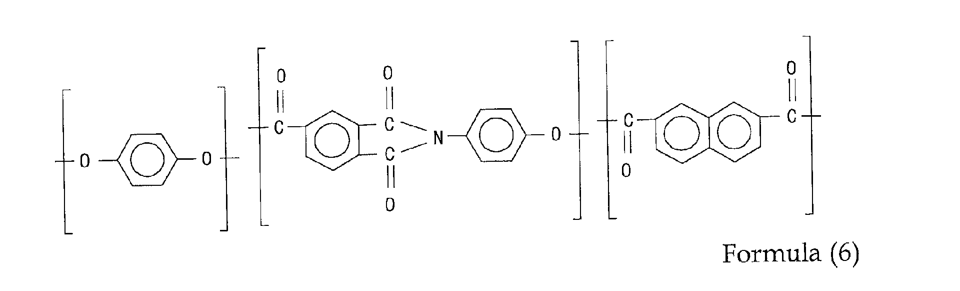

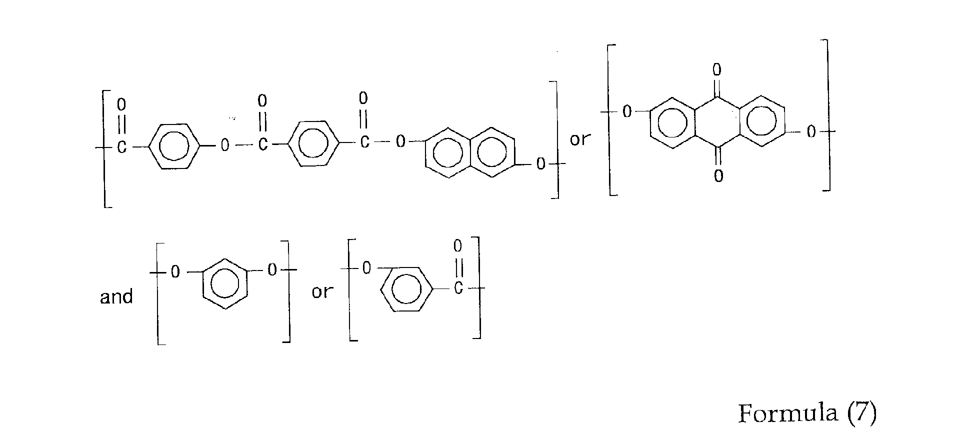

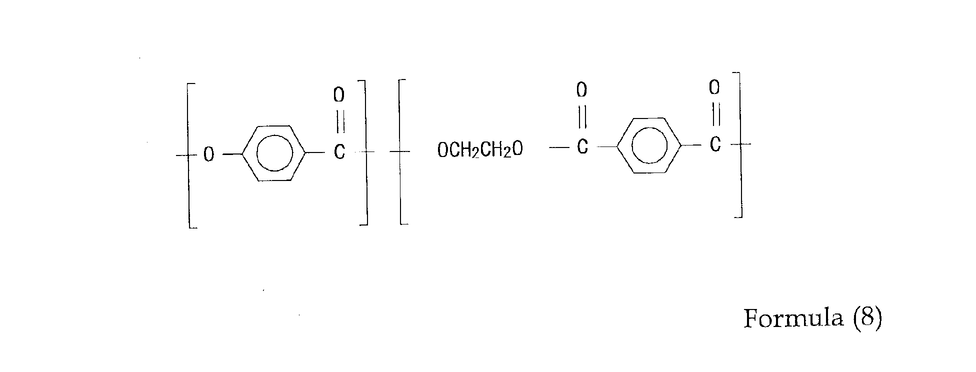

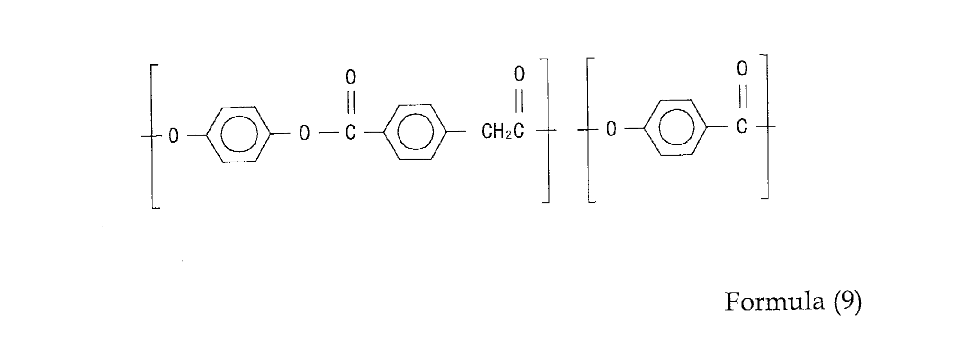

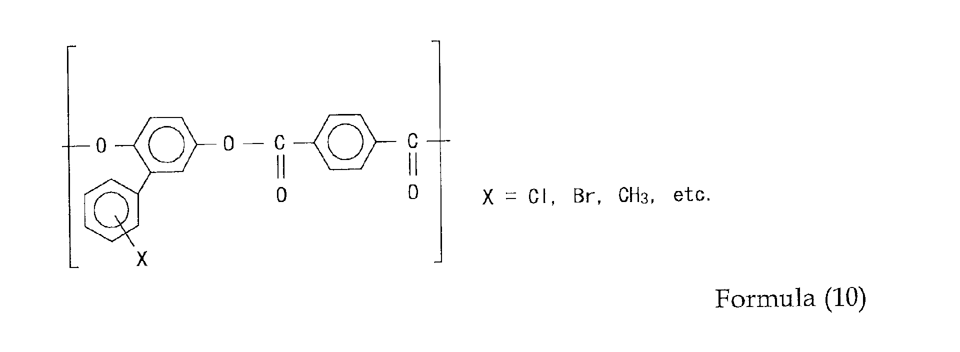

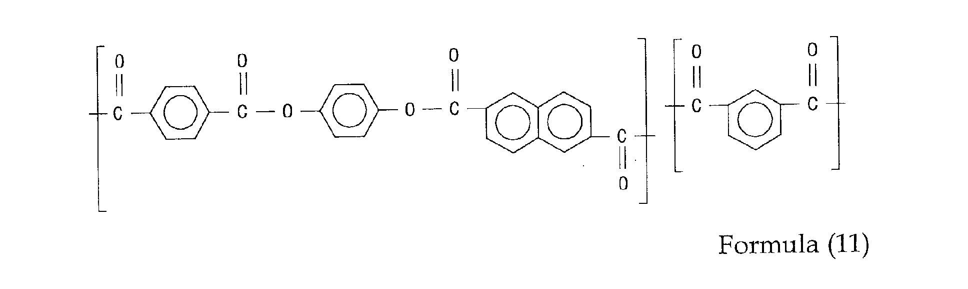

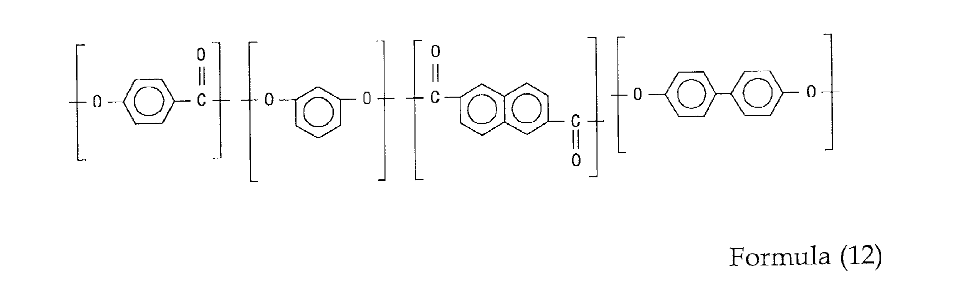

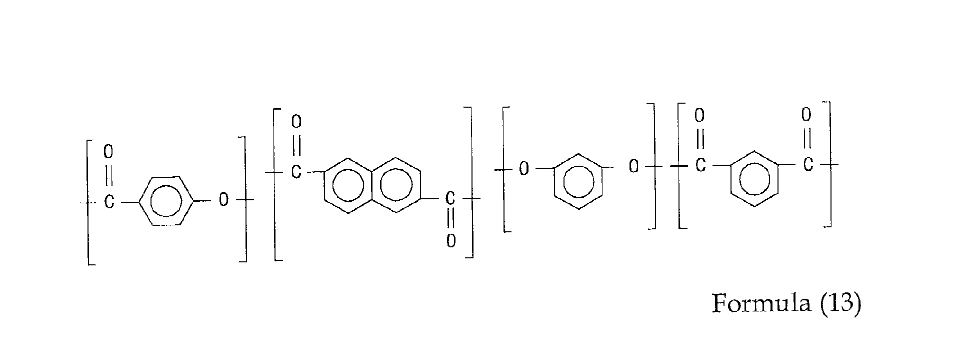

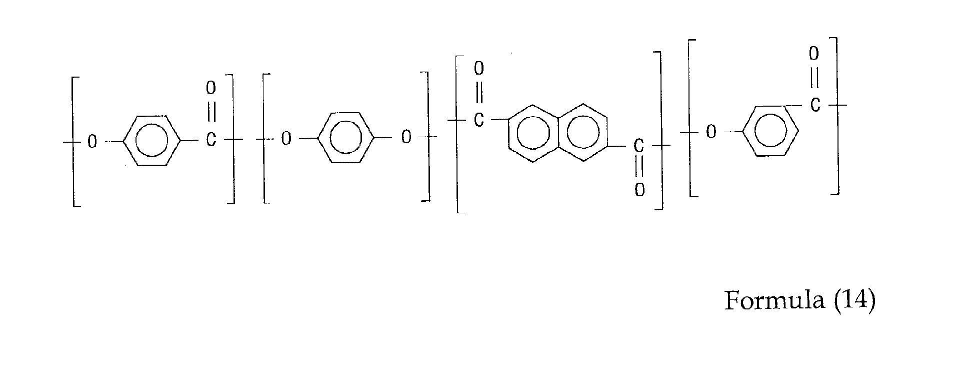

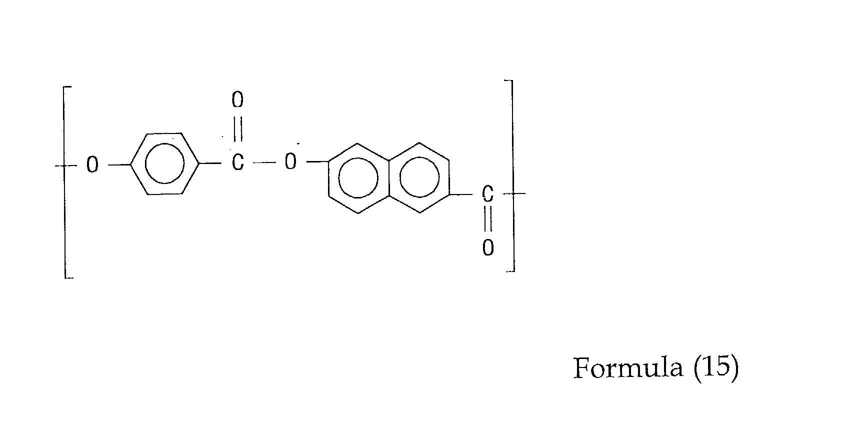

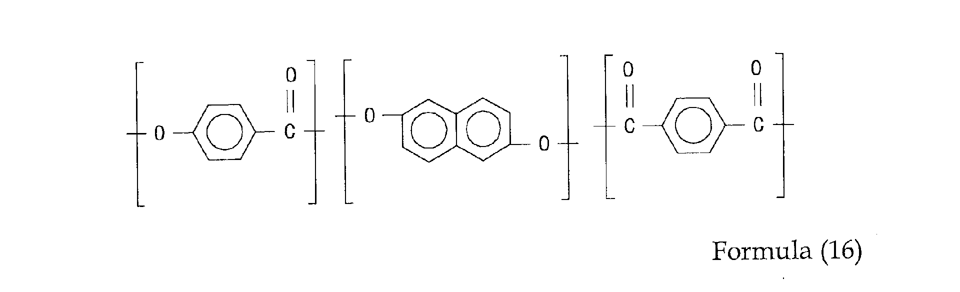

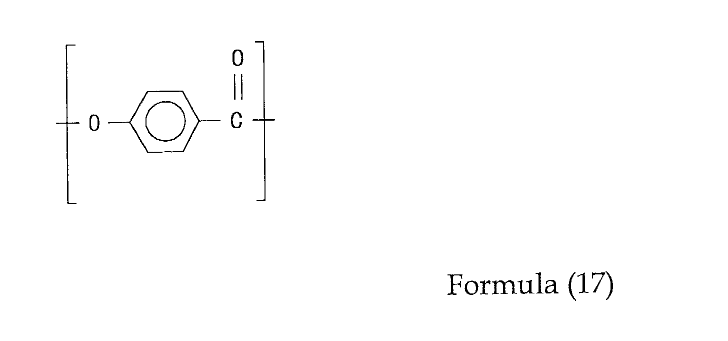

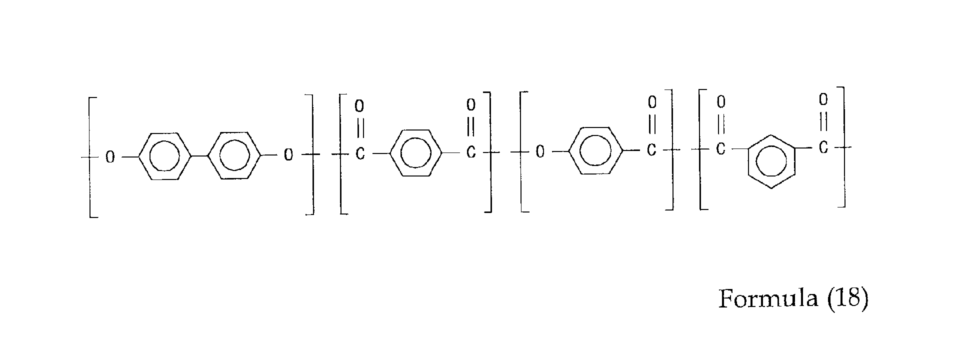

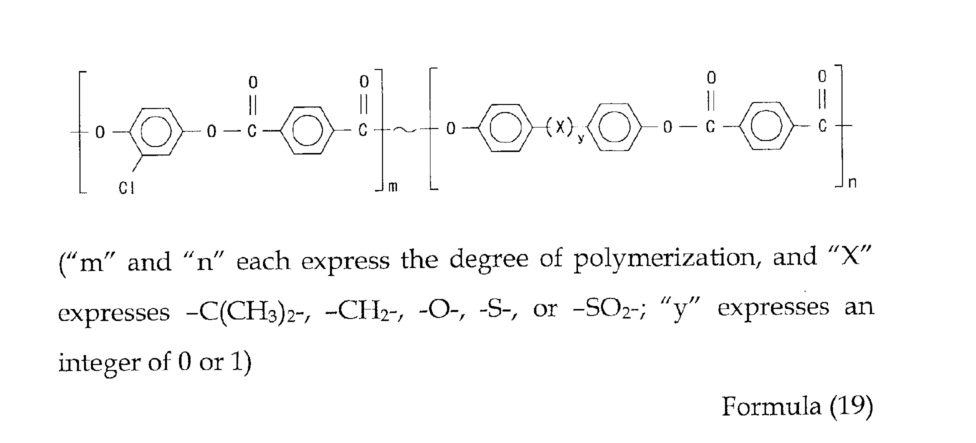

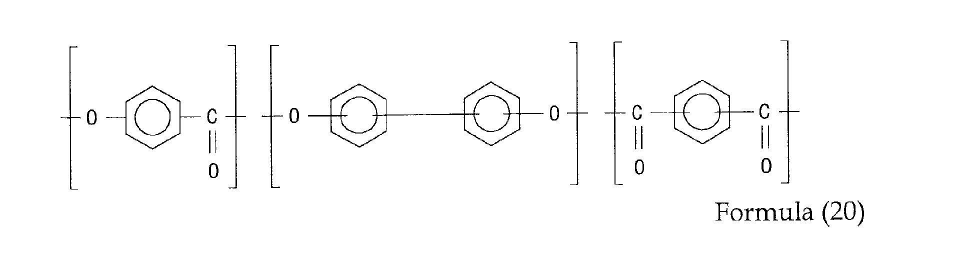

There are no particular limitations on a process for synthesizing the main chain liquid crystal polymer, and can be suitably selected according to purposes. Examples include various processes for synthesizing as shown in the following schemes, and the like. Note that, in general, the main chain liquid crystal polymer which has different degree of condensation, can be synthesized by appropriately selecting the reaction temperature and the reaction time, even if a molar ratio of the monomer is stable.

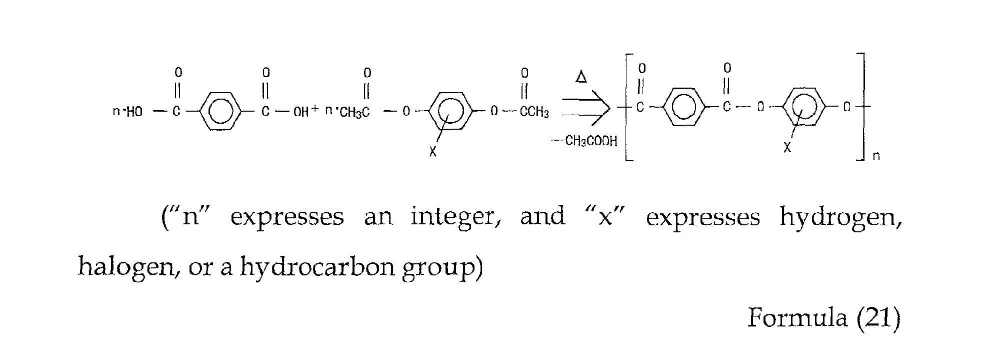

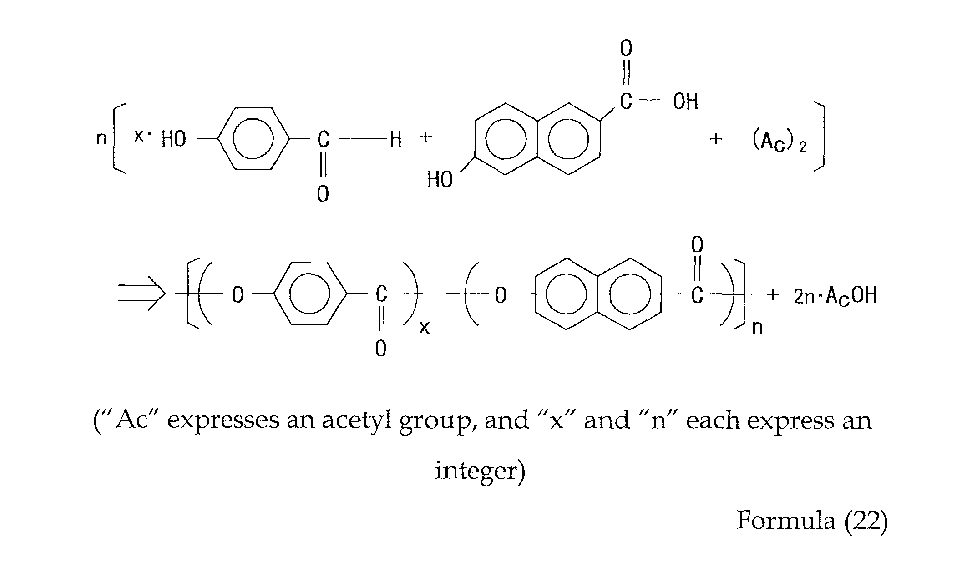

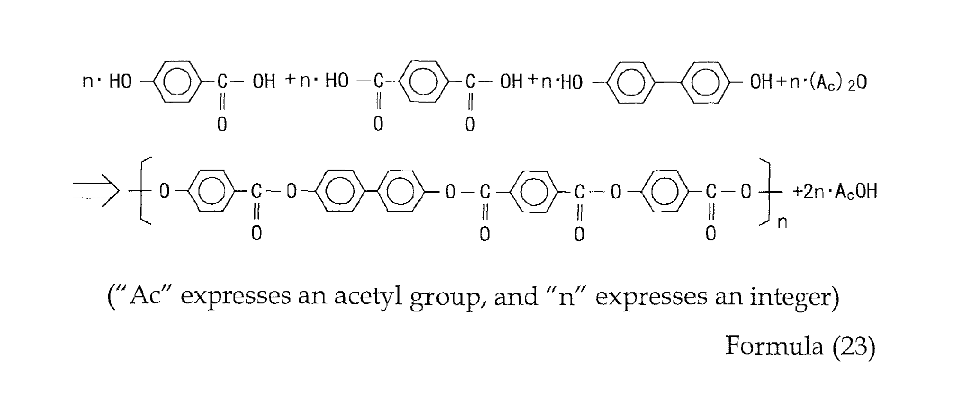

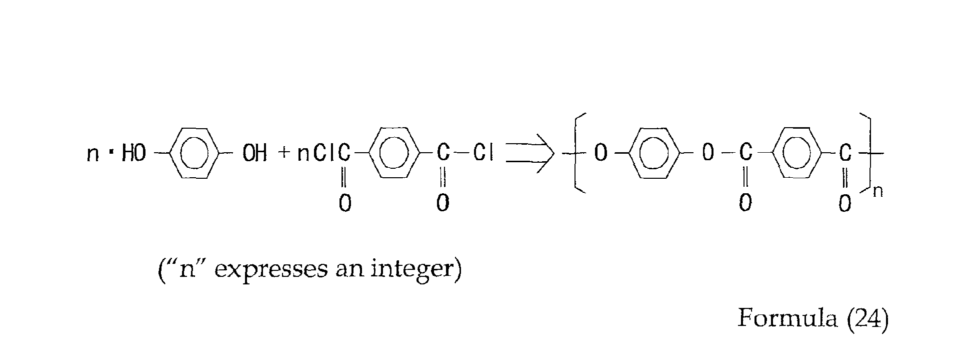

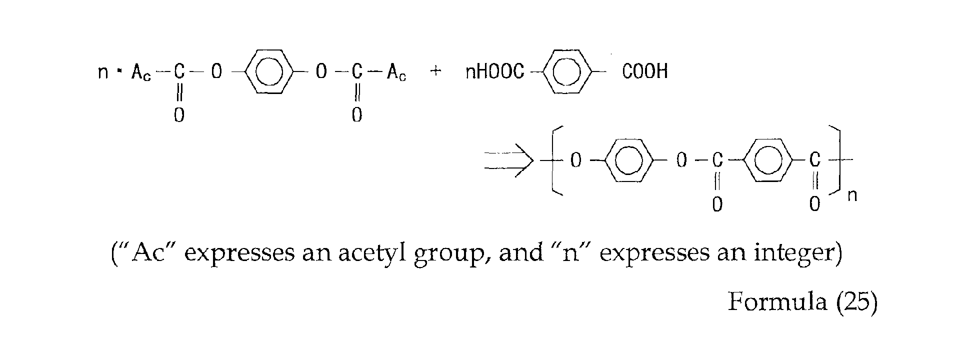

The main chain liquid crystal polymer can be suitably synthesized, or can be a commercial product.

Examples of the commercial product include "Zenite (registered Trademark) "available from Du Pont Kabushiki Kaisha, "Sumika super (registered Trademark)" available from Sumitomo Chemical Co., Ltd., "Vectran (registered Trademark)" available from Kuraray Co., Ltd., "Octa (registered Trademark)" available from DAINIPPON INK AND CHEMICALS INCORPORATED, "Vectra (registered Trademark)" available from Polyplastics Co., Ltd., "Rodrun" available from Unitika Ltd., "Xydar (registered Trademark)" available from Nippon Sekiyu Kagaku Kogyo Kabushiki Kaisha, "Novaccurate (registered Trademark)" available from Mitsubishi Engineering-Plastics Corporation, "Siveras (registered Trademark)" available from Toray Industries, Inc., and the like.

The main chain liquid crystal polymer preferably exhibits SHG (Second Harmonic Generation) activity, and preferably has a maximum polarizability in a direction substantially parallel to a main chain thereof.

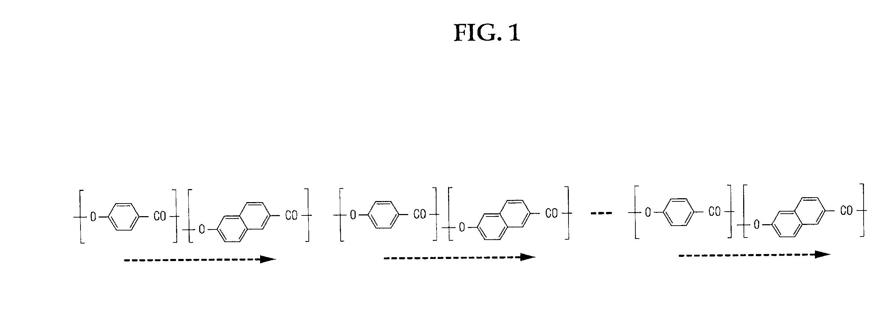

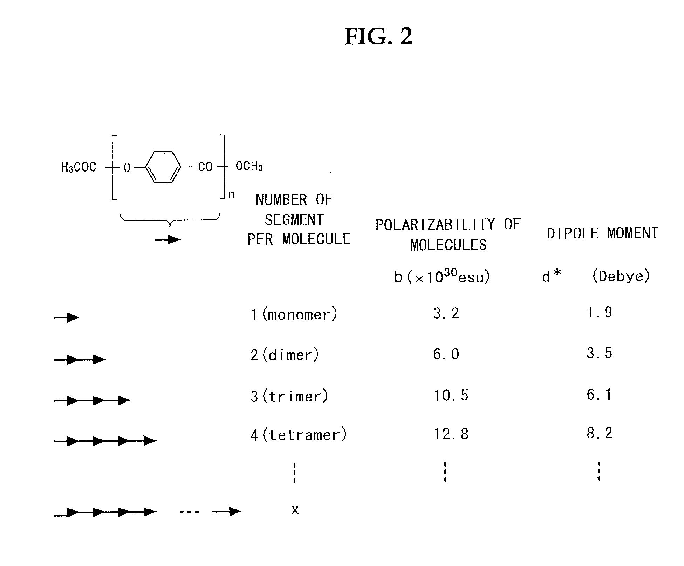

The reason that the main chain liquid crystal polymer shows SHG (Second Harmonic Generation) activity is assumingly as follows. Referring into FIGs. 1 and 2 (refer to, T. Watanabe et al. *Jpn. J. Appl. Phys.* (1996) vol. 35 L 505), the polarizability increases in accordance with polymerization degree of a monomer unit of the main chain liquid crystal polymer. When a molecular weight of the main chain liquid crystal polymer increases and a dipole moment, "d^{*}," exceeds a certain point, the main chain liquid crystal polymer has a phase structure which have no symmetry center.

There are particularly no limitations on other component(s) for the material for piezoelectric transduction, and can be suitably selected according to purposes. Examples of the other component(s) include a polymer for adhesion which enables easier film-forming, and the like. Examples of the polymer for adhesion include known binder resins, and the like.

Examples of the known binder resins include a thermoplastic resin, rubber (elastomer rubber), an adhesive, monomer and oligomer, polymer alloy, polyimide, a natural product, an inorganic product, and the like.

Examples of the thermoplastic resin include poly vinylacetate (PVAc), poly vinylalcohol (PVA), poly vinylbutylal (PVB), acrylic copolymer (acryl), polyethylene (PE), ethylene-vinyl acetate copolymer (EVA), vinyl chloride plus-sol, poly vinyl chloride-vinyl acetate copolymer, poly vinyl pyrrolidine, nylon 11,12 copolymerized nylon, copolymer of polyethylene terephthalate, poly butylene terephthalate, a urea resin, a melamine resin, a phenolic resin, a resorcinol resin, an epoxy resin, polyurethane, vinylurethane, and the like.

Examples of the rubber include polyisoprene natural rubber, synthetic polyisoprene rubber, polychloroprene, acrylonitrile-butadiene copolymer, styrene-butadiene copolymer, styrene-butadiene-vinyl pyridine terpolymer, poly isobutylene, butyl rubber, poly sulfide, room temperature vulcanizing silicone rubber, chlorinated rubber, brominated rubber, graft polychloroprene, styrene-isoprene-styrene, styrene-butadiene-styrene, and the like.

Examples of the adhesive include a pressure sensitive adhesive, an acrylic adhesive, a silicone adhesive, and the like.

Examples of the monomer and oligomer include cyanoacrylate, an ultraviolet hardening adhesive, a visible light hardening adhesive, an electron beam hardening adhesive, and the like.

Examples of the polymer alloy include poly vinylformal/phenolic, poly vinylbutyral/phenolic, nitrile rubber/phenolic, nitrile rubber/epoxy, liquid nitrile rubber/epoxy, epoxy/phenolic, and the like.

Examples of the natural product include starch, dextrin, and the like.

Examples of the inorganic products include sodium silicate, ceramics, and the like.

There are no particular limitations on a content of the other component(s) in the material for piezoelectric transduction, and can be suitably adjusted as long as it does not negatively influence the effect of the present invention.

The material for piezoelectric transduction may be formed into various shapes. The material for piezoelectric transduction is preferably formed into one of a film shape, a linear shape, a rod shape, a planar shape, a granular shape, a cubic shape, or the like.

### --Process for Manufacturing Material for Piezoelectric Transduction--

The process for manufacturing a material for piezoelectric transduction is not specifically limited, and can be selected appropriately in accordance with the object. A preferred example includes using a main chain liquid crystal polymer synthesized by the process as described above, forming the main chain liquid crystal polymer into a body having a desired shape by a process selected from applying, molding (forming), press forming, or the like, and then conducting a poling treatment to the formed body.

A process for applying the main chain liquid crystal polymer is not specifically limited, and can be selected appropriately from the known processes in accordance with the object. Examples of the applying process include spin coating method, bar coating method, knead coating method, curtain coating method, blade coating method, and the like. Additionally, it is preferred that the material for piezoelectric transduction is applied on a rubbed surface. A process for forming the rubbed surface is not specifically limited, and can be selected appropriately in accordance with the object.

A solvent may be used for the application of the main chain liquid crystal polymer. The solvent is not specifically limited, and can be selected appropriately in accordance with the object. The solvent may be used either alone or in combination of two or more.

A process for molding (including forming) the main chain liquid crystal polymer is not specifically limited, and can be selected appropriately from the known processes in accordance with the object. Examples of the process for molding include compression molding method, transfer molding method, injection molding method, powder molding method, rotational molding method, blow molding method, injection blow molding method, extrusion blow molding method, extrusion molding method, calender molding method, thermoforming method, pressure molding method, flow molding method, paste forming method, vacuum molding method, foam molding method, lamination molding method, and the like.

The process for the press forming is not specifically limited, and can be selected appropriately from the known processes in accordance with the object.

The poling treatment is not specifically limited, and can be selected appropriately in accordance with the object. In one example, the formed body (material for piezoelectric transduction) is fixed on a hot plate, a tungsten needle is placed at an appropriately selected distance from the formed body, and an arbitrary voltage is applied to the tungsten needle in order to conduct the treatment. In this example, it is preferred to keep the temperature of the formed body at the softening point of the formed body or more.

The material for piezoelectric transduction preferably has a decay rate of 0.1 or less, more preferably 0.05 or less, and particularly preferably 0. Here, the decay rate is defined as ((α-β)/α), in which "α" is the piezoelectricity of the material for piezoelectric transduction at room temperature prior to heating, and "β" is the piezoelecricity of the material for piezoelectric transduction at room temperature after seven days of continuous heating at 85 °C.

A method of measuring the piezoelectricity is not specifically limited, and can be measured using a method which is selected appropriately in accordance with the object. For example, one can use a piezoelectricity measurement device, e.g., a d33 meter, to readily measure the piezoelectricity.

A material for piezoelectric transduction having a decay rate of or less than 0.1 is advantageous from the standpoint that the material maintains sufficient piezoelectricity even though being left at high temperature for a long period and can suitably be used in a usage that requires heat resistance.

The material for piezoelectric transduction can be suitably utilized in various fields directly, including, for example, piezo film, an acceleration sensor, a microphone, an impact sensor, a dynamic strain meter, a speaker, an infrared ray sensor, a temperature change sensor, and the like. It can also be utilized as a composite material for piezoelectric transduction together with a matrix material, which can also be suitably applied to a damping material.

The present invention will be described in more detail referring into EXAMPLEs, hereinafter. The present invention is not limited to the EXAMPLES, however.

### (EXAMPLE 1)

### --Synthesis of Main Chain Liquid Crystal Polymer--

137 parts by mass of 4-acetoxy benzoic acid, 63 party by mass of 6-acetoxy-2-naphthoic acid, and 0.01 part by mass of potassium acetate, were placed in a reaction container, were then raised in temperature to 150°C while stirring, and were hence fully subjected to nitrogen-substitution. It was then further raised in temperature to 300°C while stirring, and a pressure in the reaction container was gradually reduced while removing newly generating acetic acid. It was stirred in the above state for 1 hour. Thus, a main chain liquid crystal polymer A expressed by the following Formula (1) was synthesized.

A small amount of the main chain liquid crystal polymer A was provided between two plates of glass. Temperature at which softening began was observed using a polarization miroscope with heating, and was found out to be about 310°C.

The ratio of m to n in the following Formula (1) was m:n = 73:27.

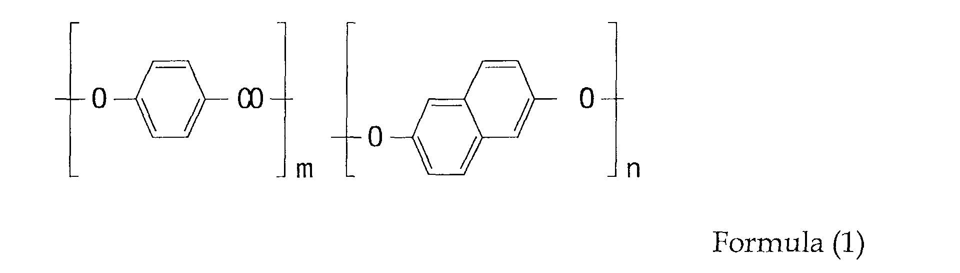

### --Poling Treatment--

The main chain liquid crystal polymer A was pressed to a thickness of around 200µm, so as to prepare a sample sheet A. The sample sheet A was fixed on a hot plate. Tungsten needle was placed 1.5cm above the upper surface of the sample sheet A, and voltage of 9.5kV was applied to the tungsten needle, so as to provide a corona poling treatment. Thus, a sheet-shaped material for piezoelectric transduction A was made. An evaluation of the decay rate of the material for piezoelectric transduction A was conducted as described hereafter. The result is shown in Table 3.

During the corona poling treatment, the temperature of the sample sheet A was maintained at 320° C.

Piezoelectricity α of the material for piezoelectric transduction A at room temperature prior to heating was measured by a d33 meter, and was found out to be 5.8pC/N. Piezoelectricity β of the material for piezoelectric transduction A was measured at room temperature in the same manner after being heated for 7 days at 85°C. The piezoelectricity β was 5.8pC/N. According to the measurements of α and β, a decay rate (piezoelectricity α -piezoelectricity β)/piezoelectricity α) of the material for piezoelectric transduction A was calculated. The decay rate was 0.

### (EXAMPLE 2)

### --Synthesis of Main Chain Liquid Crystal Polymer--

137 parts by mass of 4-acetoxy benzoic acid, 63 parts by mass of 6-acetoxy-2-naphthoic acid, and 0.01 part by mass of potassium acetate, were placed in a reaction container, were then raised in temperature to 150°C while stirring, and were hence fully subjected to nitrogen-substitution. It was then further raised in temperature to 250°C while stirring, and a pressure in the reaction container was gradually reduced while removing newly generating acetic acid. It was stirred in the above state for 3 hours. Thus, a main chain liquid crystal polymer B expressed by the following formula (1) was synthesized.

A small amount of the main chain liquid crystal polymer B was provided between two plates of glass. Temperature at which softening began was observed using a polarization miroscope with heating, and was found out to be 240°C.

The ratio of m to n in the following formula (1) was m:n = 73:27.

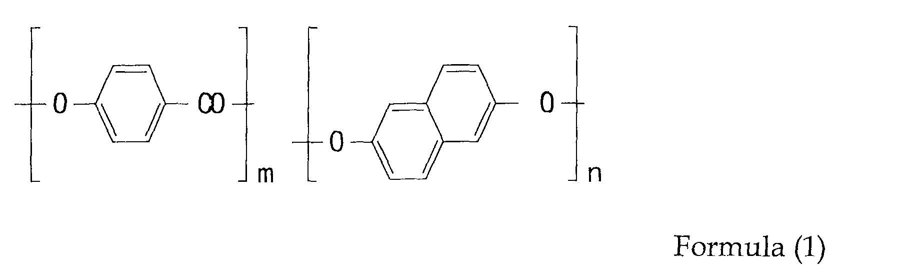

In the same manner as in EXAMPLE 1, the main chain liquid crystal polymer B was used to prepare a sample sheet B (thickness of about 200µm). The corona poling treatment was conducted on the sample sheet B, and a sheet-shaped material for piezoelectric transduction B was made. During the corona poling treatment, the temperature of the sample sheet B was maintained at 260 °C.

Piezoelectricity values of the material for piezoelectric transduction B was measured in the same manner as in EXAMPLE 1. The piezoelectricity α was 1.2 pC/N, and piezoelectricity β was 1.1 pC/N. According to the measurements of α and β, a decay rate (piezoelectricity α -piezoelectricity β)/piezoelectricity α) of the material for piezoelectric transduction B was calculated. The decay rate was 0.08. The result is shown in Table 3.

### (EXAMPLE 3)

### --Synthesis of Main Chain Liquid Crystal Polymer--

137 parts by mass of 4-acetoxy benzoic acid, 63 parts by mass of 6-acetoxy-2-naphthoic acid, and 0.01 part by mass of potassium acetate, were placed in a reaction container, were then raised in temperature to 150°C while stirring, and were hence fully subjected to nitrogen-substitution. It was then further raised in temperature to 280° C while stirring, and a pressure in the reaction container was gradually reduced while removing newly generating acetic acid. It was stirred in the above state for 1.5 hours. Thus, a main chain liquid crystal polymer C expressed by the following Formula (1) was synthesized.

A small amount of the main chain liquid crystal polymer C was provided between two plates of glass. Temperature at which softening began was observed using a polarization miroscope with heating, and was found out to be 270°C.

The ratio of m to n in the following Formula (1) was m:n = 73 :27.

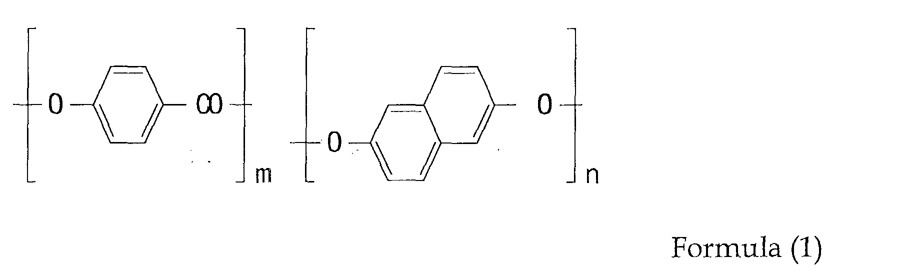

In the same manner as in EXAMPLE 1, the main chain liquid crystal polymer C was used to prepare a sample sheet C (thickness of about 200 µm). The corona poling treatment was conducted on the sample sheet C, and a sheet-shaped material for piezoelectric transduction C was made. During the corona poling treatment, the temperature of the sample sheet C was maintained at 280 °C.

Piezoelectricity values of the material for piezoelectric transduction C was measured in the same manner as in EXAMPLE 1. The piezoelectricity α was 7.4 pC/N, and piezoelectricity β was 7.2 pC/N. According to the measurements of α and β, a decay rate (piezoelectricity α -piezoelectricity β)/piezoelectricity α) of the material for piezoelectric transduction C was calculated. The decay rate was 0.03. The result is shown in Table 3.

### (EXAMPLE 4)

### --Synthesis of Main Chain Liquid Crystal Polymer--

137 parts by mass of 4-acetoxy benzoic acid, 63 parts by mass of 6-acetoxy-2-naphthoic acid, and 0.01 part by mass of potassium acetate, were placed in a reaction container, were then raised in temperature to 150°C while stirring, and were hence fully subjected to nitrogen-substitution. It was then further raised in temperature to 290° C while stirring, and a pressure in the reaction container was gradually reduced while removing newly generating acetic acid. It was stirred in the above state for 1 hour. Thus, a main chain liquid crystal polymer D expressed by the following Formula (1) was synthesized.

A small amount of the main chain liquid crystal polymer D was provided between two plates of glass. Temperature at which softening began was observed using a polarization miroscope with heating, and was found out to be 285°C.

The ratio of m to n in the following formula (1) was m:n = 73:27.

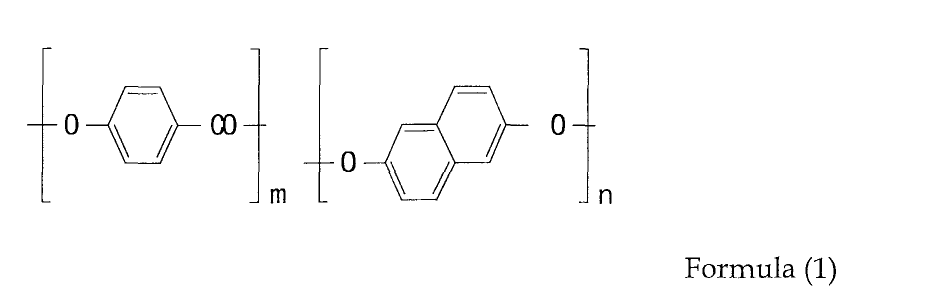

In the same manner as in EXAMPLE 1, the main chain liquid crystal polymer D was used to prepare a sample sheet D (thickness of about 200 µm). The corona poling treatment was conducted on the sample sheet D, and a sheet-shaped material for piezoelectric transduction D was made. During the corona poling treatment, the temperature of the sample sheet D was maintained at 295 °C.

Piezoelectricity values of the material for piezoelectric transduction D was measured in the same manner as in EXAMPLE 1. The piezoelectricity α was 9.5 pC/N, and piezoelectricity β was 9.4 pC/N. According to the measurements of α and β, a decay rate ((piezoelectricity α -piezoelectricity β)/piezoelectricity α) of the material for piezoelectric transduction D was calculated. The decay rate was 0.01. The result is shown in Table 3.

### (COMPARATIVE EXAMPLE 1)

Using a PVDF piezoelectric film (thickness of about 110 µm), piezoelectricity values of the film were measured in the same manner as in EXAMPLE 1. The piezoelectricity α was 25.0 pC/N, and piezoelectricity β was 17.6 pC/N. According to the measurements of α and β, a decay rate ((piezoelectricity α -piezoelectricity β)/piezoelectricity α) of the PVDF piezoelectric film was calculated. The decay rate was 0.30. The result is shown in Table 3.

**TABLE 3**

| | d33 (pC/N) | d33 (pC/N, 85°C·7days) | Decay rate |
|---|---|---|---|
| EX. 1 (material A) | 5.8 | 5.8 | 0.00 |
| EX. 2 (material B) | 1.2 | 1.1 | 0.08 |
| EX. 3 (material C) | 7.4 | 7.2 | 0.03 |
| EX. 4 (material D) | 9.5 | 9.4 | 0.01 |
| COMP. EX. 1 (PVDF) | 25.0 | 17.6 | 0.30 |

As shown in TABLE 3, piezoelectricity of the EXAMPLEs 1 to 4 shows very little decay even after being kept at 85 °C for 7 days. On the other hand, piezoelectricity of the COMPARATIVE EXAMPLE 1 (PVDF) shows around 30% of decay. Accordingly, it was found out that the material for piezoelectric transduction of the present invention was able to maintain stable piezoelectricity even after being kept at high temperature for a long period.

### (EXAMPLE 5)

A copolymer of hydroxybenzoic acid (HBA) and 6-hydroxy-2-naphthoic acid (HNA), which is a liquid crystal of aromatic polyester, was synthesized. The copolymer, in which the molar ratio of HBA to HNA was about 70 to 30, was expressed by the following formula (1).

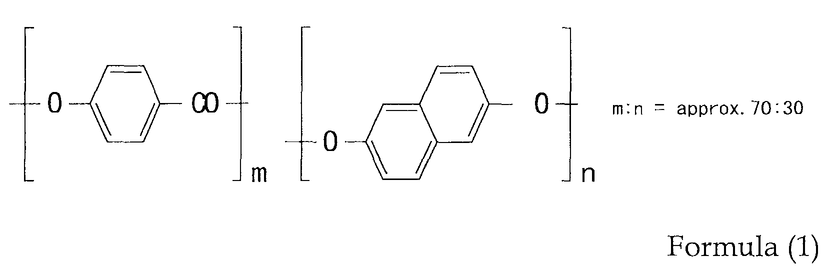

A relatively strong second harmonic generation (SHG) was observed in the liquid crystal of aromatic polyester, confirming that a ferroelectric nematic phase was developing and that the liquid crystal could function as a material for piezoelectric transduction.

The present invention solves problems in the related art, and provides a material for piezoelectric tranduction which maintains sufficient piezoelectric performance even if stored at high temperature for a long period, can be suitable for usage when requiring heat resistance, can be produced at low cost, and is excellent in mass production and handling.

## Claims

1. A material for piezoelectric transduction comprising:
a main chain liquid crystal polymer.

2. A material for piezoelectric transduction according to Claim 1, wherein the main chain liquid crystal polymer contains a constitutional unit having a cyclic group, as a repeated unit.

3. A material for piezoelectric transduction according to one of Claims 1 and 2, wherein the main chain liquid crystal polyester is at least one selected from polyesters.

4. A material for piezoelectric transduction according to one of Claims 1 and 2, wherein the main chain liquid crystal polyester is at least one selected from aromatic polymers.

5. A material for piezoelectric transduction according to Claim 4, wherein the aromatic polymer is at least one selected from aromatic polyesters.

6. A material for piezoelectric transduction according to Claim 5, wherein the aromatic polyester has at least one selected from aromatic diol, aromatic dicarboxylic acid, and hydroxycarboxylic acid, as a monomer unit of the aromatic polyester.

7. A material for piezoelectric transduction according to Claim 4, wherein the aromatic polymer contains a structure expressed by the following Formula (1): 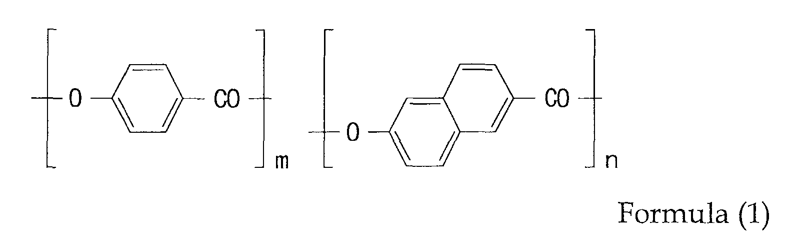 wherein "m" and "n" each express a degree of polymerization.

8. A material for piezoelectric transduction according to any one of Claims 1 to 7, wherein the main chain liquid crystal polymer shows second harmonic generation activity.

9. A material for piezoelectric transduction according to any one of Claims 1 to 8, wherein the main chain liquid crystal polymer has a maximum polarizability in a direction substantially parallel to a main chain thereof.

10. A material for piezoelectric transduction according to any one of Claims 1 to 9, wherein the material for piezoelectric transduction has one of a linear shape, a rod shape, a planar shape, a granular shape, and a cubic shape.

11. A material for piezoelectric transduction according to any one of Claims 1 to 10, further comprising:
a polymer for adhesion.

12. A material for piezoelectric transduction according to any one of Claims 1 to 11, wherein a decay rate of the material for piezoelectric transduction is 0.1, or less, and the decay rate is defined as:
(piezoelectricity α- piezoelectricityβ)/ piezoelectricityα);
wherein "α" expresses a piezoelectricity of the material for piezoelectric transduction at room temperature prior to heating and "β" is a piezoelectricity of the material for piezoelectric transduction at room temperature after seven days of continuous heating at 85°C.

13. A material for piezoelectric transduction according to any one of Claims 1 to 12, wherein the material for piezoelectric transduction is utilized as a damping material.
